Europäisches Patentamt

(19) European Patent Office

Office européen des brevets

(11) Publication number: **0 037 793**
**B1**

(12) **EUROPEAN PATENT SPECIFICATION**

(45) Date of publication of patent specification: **11.03.87**

(51) Int. Cl.⁴: $H\ 04\ B\ 9/00$, $G\ 02\ B\ 6/26$, $G\ 02\ F\ 1/29$

(21) Application number: **81630027.1**

(22) Date of filing: **31.03.81**

(54) optical communication transmission system.

(30) Priority: **31.03.80 US 135798**

(43) Date of publication of application:
**14.10.81 Bulletin 81/41**

(45) Publication of the grant of the patent:
**11.03.87 Bulletin 87/11**

(84) Designated Contracting States:
**DE FR GB NL**

(56) References cited:
**EP-A-0 000 647**
**GB-A-1 304 153**
**GB-A-1 373 956**
**US-A-3 408 131**
**US-A-3 558 213**
**US-A-3 589 794**
**US-A-3 957 341**
**US-A-3 964 819**
**US-A-4 026 632**
**US-A-4 054 366**

**ELECTRONICS AND COMMUNICATIONS IN JAPAN, vol. 61-B, no. 5, 1978, Washington, T. YONEYAMA et al. "Coupling of a single-mode waveguide and a multi-mode waveguide", pages 80-86**

(73) Proprietor: **POLAROID CORPORATION**
**549 Technology Square**
**Cambridge, Massachusetts 02139 (US)**

(72) Inventor: **Hicks, John Wilbur, Jr.**
**P.O. Box 345 167 Dresser Street**
**Southbridge, MA 01550 (US)**

(74) Representative: **Haibach, Tino, Dr. et al**
**Patentanwälte Dipl.-Ing. C. Wallach; Dipl.-Ing. G. Koch Dr. T. Haibach; Dipl.-Ing. R. Feldkamp P.O. Box 920**
**D-8000 Munich 33 (DE)**

(56) References cited:
**IEEE JOURNAL OF QUANTUM ELECTRONICS, vol. QE-14, no. 8, 1978, New York, P.S. CROSS et al. "Optically controlled two channel integrated-optical switch", pages 577-580**

**THE TRANSACTIONS OF THE IECE OF JAPAN, vol. E62, no. 1, 1979, Tokyo, Y. YAMAMOTO et al. "Low loss splice of single-mode-fibers using tapered velocity couplers", pages 11-17**

**APPLIED OPTICS, vol. 19, no. 3, 1980, New York, Y. MURAKAMI "Coupling between curved dielectric waveguides", pages 398-403**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The invention relates to optical communication transmission systems of the general type comprising a main transmission wave guide for supporting optical wave energy at a plurality of wave lengths, and branch wave guides coupled to the main wave guide for selectively extracting wave energy from, or feeding to, said main wave guide. More particularly, the invention is concerned with an optical communication transmission system of this general type, wherein the wave energy couplings between the main wave guide and said branch wave guides each are provided with a frequency-selective capability whereby wave energy within a narrow band around a predetermined coupling frequency only would be transmitted or branched-off at each coupling site from the main to the respective branch wave guide or vice-versa, thus resulting in a communication system of the frequency-multiplexing type providing selective communication between a (plurality of) transmitting station(s) and a plurality of receiving stations, utilizing a single main transmission wave guide operable at a (plurality of) particular wave length(s) serving as a common communication channel between selected pairs of said transmitting station(s) and receiving stations, in a frequency multiplexing way of operation. Such optical communication transmission system with frequency-selective coupling between the main and associated branch wave guides obviously would have a number of important and interesting applications such as in the classical field of communication proper like telephone networks, where wave length multiplexing of the forementioned type could be used in the terminal distribution networks as a means of addressing individual subscribers. Another potential field of application would be more "compact" systems such as an array of interconnected computers at one location.

In connection with coupling for wave energy transfer between optical wave guides, evanescent coupling of optical energy between wave guides is a well-known phenomenon. In evanescent coupling, the two wave guides to be coupled are arranged in proximate, preferably parallel, spatial relationship over a coupling length, whereby a certain amount of wave energy may be transferred from one wave guide to the other. In particular, transfer of substantially all the wave energy in one waveguide to an adjacent physically identical waveguide by evanescent coupling is well known. It is also known, in connection with so-called channel optical waveguide forms, to provide frequency-selective evanescent or lateral (FSEL) coupling between waveguides. For instance, U.S. Patent No. 3,957,341 discloses a passive frequency selective optical coupler in which first and second dielectric waveguides of the channel or slab type are provided having phase propagation constants which can be made to match at a predetermined frequency. At all other frequencies the phase propagation constants of the waveguides are said to be different.

The dielectric waveguides are arranged at proximate spatial disposition relative to each other for a sufficient length and extent to bring about selective coupling of light energy between the waveguides at the known predetermined frequency at which guided modes of the waveguides possess identical phase propagation constants. Coupling at all other frequencies is said to be inhibited. Identity of guided mode phase propagation constants at only one frequency in the waveguides is achieved because the waveguides have either different refractive indices or different physical dimensions or both. The dielectric channels of waveguide material are deposited on a substrate and are separated from each other by layers or films having a refractive index different from either of the waveguides. While such devices may be capable of frequency selective coupling of optical energy, they are thought not to be efficient owing to high losses on account of the separation of the waveguides by the layer or film. Moreover, such devices suffer from the complication inherent in connecting them to an optical communications system, such as an optical clad fibre system.

Attempts have also been made for seeking direct couples between fibre optic strands. U.S. Patent No. 4,054,366 discloses a fiber optics access coupler in which strands of optical fibres of the multi-mode kind are put into coupling relationship by fusing their claddings by means of a laser beam. As is evident from the disclosure of the patent, signal transfer efficiency is not of the kind that would render the system susceptible to practical exploitation. Moreover, no concern is given to frequency selective coupling. Rather, the disclosure deals with coupling per se between multi-mode fibres.

Thus, being based on prior art such as exemplified by formentioned U.S. Patent No. 3,957,341, the invention relates to an optical communication transmission system comprising a main transmission wave guide for supporting optical wave energy at a plurality of wave lengths, at least one branch wave guide coupled to the main wave guide for transferring, between said main and branch wave guides, wave energy at but a single predetermined one of said plurality of wave lengths, said transfer of wave energy between said main and each branch wave guide being achieved utilizing the principle of frequency-selective lateral evanescent wave coupling under which the wave guides so coupled are arranged in proximate parallel relationship over a coupling length and are selected to have dispersion characteristic curves different from one another over said coupling length but crossing at the desired coupling wave length, whereby the two coupled wave guides will have matching phase propagation constants at said coupling wave length only, whereas there will be mismatch of phase propagation constants between the two coupled wave guides over the coupling length for all other wave lengths.

It is a task of the present invention to provide an optical communication system of this general type which while structurally simple and easy and cheap to manufacture and maintain provides a highly efficient mechanism for frequency-selective coupling between the wave guides, both as to the degree of selectivity and low-loss transmittance characteristics, and therefore lends itself for practical use in the above mentioned potential fields of optical communication transmission systems of the frequency multiplexing type.

With a view thereto, in an optical communication system of the type set out above, provision is made in accordance with the present invention that (a) coupling between the main wave guide and each branch wave guide is via a coupling wave guide each, (b) said main, branch and coupling wave guides are non-planar optical fibres each comprising a core circumferentially embedded in a cladding; (c) said fibre wave guides are of the kind selected to support waves in a single mode only; (d) the main guide and each coupling wave guide are selected to have different dispersion characteristics of phase velocity of the optical wave energy over the coupling length and each coupling wave guide, over its coupling length with the main wave guide, is of a physical condition imparting to the coupling wave guide a phase velocity of the optical wave energy at said one wave length which matches the phase velocity of said one wave length in the main guide, whereby energy at said coupling wave length to the exclusion of all other wave lengths is transferred from the main guide to the respective coupling wave guide; (e) and each coupling wave guide is laterally coupled to a branch wave guide for further transmitting optical energy at said coupling wave length.

The invention makes for a very simple uncritical design of the overall system as to the types of fibre wave guides employed and allows for a substantive degree of lattitude and tolerance regarding the characteristics of the branch and even the main wave guides.

In sum total, the novel system of the present invention is structurally simple and easy and cheap to manufacture, provides for a high degree of flexibility as to number and lay-out of the transmission channels to be sustained in multiplex operation and hence provides for a highly versatile system and has superior performance characteristics as to selectivity and low-loss characteristics.

In accordance with a preferred embodiment it can be provided that the coupling region between each coupling wave guide and its associated branch wave guide is geometrically separate and spatially distant along the length of the coupling wave guide from the coupling region between the main wave guide and the coupling wave guide. This embodiment may be preferable not only in terms of ease of handling and manufacture, in view of the potentially minute dimensions of the structure, but may also be superior as to the selectivity achieved by avoiding marginal transfer of undesired signal frequencies from the main to the branch wave guide which might occur if the second coupling from the coupling wave guide to the branch wave guide were substantially in the same longitudinal region with the first coupling from the main to the coupling wave guide.

In accordance with advantageous embodiments, by making the propagation constant match/mismatch-condition governing the FSEL coupling between the main and the coupling wave guide selectively controllable, the device of the present invention may be provided with a tuning and potentially with a switching capability. Thus, a further application of the invention is to provide a tunable filter or switch. If the tuning or switching can be accomplished sufficiently rapidly, the device can be used as an amplifier, modulator or signal generator.

Other objects, features and advantages will become apparent in the following more detailed description of preferred, but nonetheless, illustrative embodiments with reference to the accompanying drawings, wherein:

Fig. 1 is a graphical representation illustrating the relationship between propagation constant and diameter for the lowest order mode, as the theoretical basis for FSEL-coupling, as used for the purposes of the present invention,

Fig. 2 provides a graphical representation illustrating the selective coupling capability achieved with the present invention to show the sharpness of filtering which is provided;

Fig. 3 is a schematic representation of a communications line illustrating tuning by bending;

Fig. 4 is a schematic representation showing a series of individual fibres functioning as filters by coupling into branch fibres;

Fig. 5 is a schematic representation of an alternative structure for the present invention showing selective coupling in a communications network, wherein the main communications fiber is bent into circles of different radii for coupling into branches;

Fig. 6 is a schematic representation illustrating the use of a light-bridging member providing coupling between two fibers;

Fig. 7 is a schematic representation of a geometry for coupling similar to that of Fig. 6 wherein a pair of fibers provides a positioning jig for another fiber;

Fig. 8 is a schematic representation showing the use of the geometry of Fig. 7 with a second transfer to a branch line in accordance with the present invention;

Fig. 8A shows the dimensions useful in the geometry of Fig. 8;

Fig. 9 illustrates the use of tapering for tuning the geometry listed by Figs. 8 and 8A;

Fig. 10 illustrates a second method of tuning by bending the assembly array whose geometry is recommended by Figs. 8 and 8A;

Fig. 11 is a schematic representation of a third method of tuning, alternative to Figs. 9 and 10, whereby index of refraction is varied in accordance with an applied pressure;

Fig. 12 is a schematic representation of a delay line comprising a closed loop with injected and/or extracted pulses;

Fig. 13 illustrates a Raman generating beam introduced to a fiber optics communication link; and

Fig. 14 shows the device according to Fig. 13, but with another Raman beam injected onto the line to reamplify the signals at chosen intervals.

Fig. 15 represents an envelope for the graphical representation of Fig. 2 for the case where two fibers are coupled together over more than one coupling length;

Fig. 16 is a representation of a transfer function for the case where the coupling length is n+1/2;

Fig. 17 is a graphical representation of the case where the central maximum becomes sharper as the coupling length is lengthened;

Fig. 18 represents a construction for increasing pressure sensitivity; and

Fig. 19 represents a compact system in the form of an optical switching station.

As mentioned, lateral resonant coupling techniques are used in the present invention, with the understanding that the cores to be coupled may be dissimilar. For instance, a first core is relatively large with a low index of refraction and another core is of lesser diameter, but with a higher index of refraction.

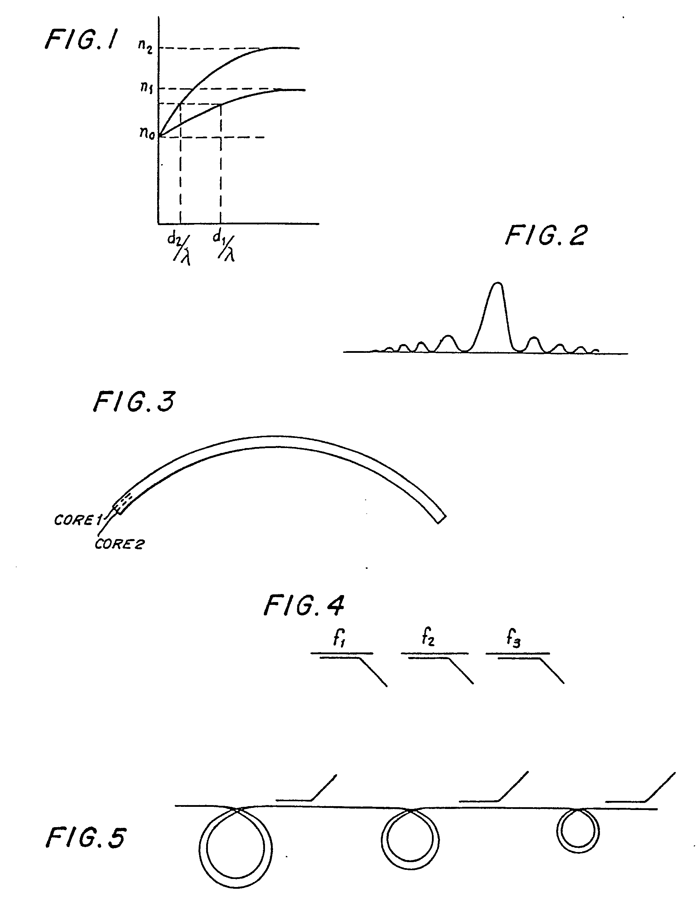

Presuming only the lowest order mode is propagated by each core at a wave length $\lambda_t$, there is some combination of diameters for the cores which enables equal propagation constants in the two fibers, despite their different indices. The propagation constant of the lowest order $HE_{11}$ mode appears as shown in Fig. 1 (approximately as a function of diameter. Such a graphical representation enables the selection of a mode matching pair of diameters.

The two cores will, at wave length $\lambda_t$, have the same propagation constant and light at that wave length will be coupled between cores in a length determined by the degree of proximity between the two cores.

If the two cores were identical, all wave lengths would resonate. However, since the two cores are not identical at other values, the propagation constants of the two cores no longer match. If the wavelength becomes shorter or longer, the propagation constants no longer match. Thus, there is only one wave length at which exact tuning occurs. In the simplest case, the fibers are in proximity only long enough for $\lambda_t$ to be completely transferred from the first core to the second core. $\lambda_t$ will be completely transferred and other wave lengths only partially transferred. This enables the described device to function as a wave length filter.

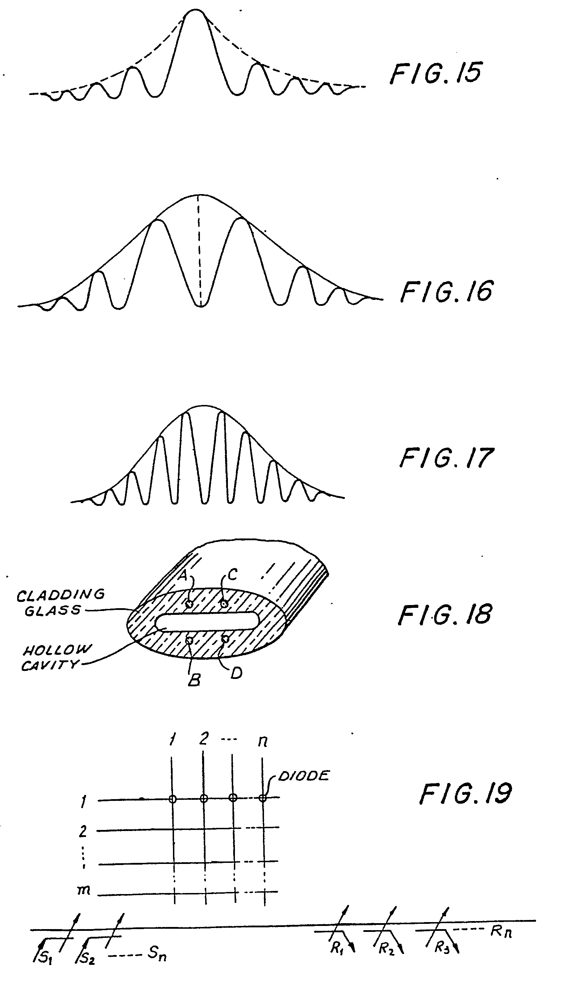

In other cases, the two fibers are coupled together over more than one coupling length. If one draws an envelope over the

$$\frac{\sin^l \theta}{\theta^L}$$

curve as shown in Fig. 15 (θ being the angle of propagation of light rays guided down the fibre, relative to the fibre axis), at any length L (along the fibre) greater than the coupling length the energy in the second fiber as a function of wave length will be bounded approximately by the envelope.

If L is n+1/2 coupling lengths, the transfer function will be as shown in Fig. 16.

As L becomes longer and L is n coupling lengths, the central maximum becomes sharper, as illustrated in Fig. 17.

The governing equations are similar to the equation for a diffraction grating. In some cases, it may be difficult to control the coupling length exactly, in which case, the fibers are coupled over several coupling lengths. One half the energy will be in the second fiber, averaged over the center of the envelope, even if the length should vary somewhat. By very slight tapering of the two fibers in the coupling region, or by bending over a slightly varying radius of curvature, the fine structure under the envelope can be removed and a relatively smooth curve of one-half the height of the original envelope will result.

As the degree of coupling is decreased and the coupling length increased, the sharpness of the filtering increases. The intensity of light transferred from the first core to the second core is as shown by Fig. 2. The first null occurs approximately when the path difference in the two cores is one-half λ in the coupling length $L_c$, that is, when

$$n_1 \cos \theta_1 L_c - n_2 \times \cos \theta_2 L_c = 1/2\lambda.$$

At $\lambda_t$ the path lengths are the same. This change in path length as a function of λ is referred to as dispersion, which can arise from the wave guide properties themselves or dispersion in the basic material. Dispersion from either source leads to a useful filter.

When two entirely independent optical signals are injected into a single core at different frequencies, with such frequencies separated at the distal end, the signal carrying capacity of the core is doubled.

A fiber filter is provided to separate wave lengths as close together as 1 mμ in the one μm region. More than 100 independent signals are thus transmitted over a single core. Accordingly, a significant decrease in cost of a basic element of a telecommunications system is thus provided.

To alter the wave length at which complete coupling occurs between two cores, bending of the two cores along a circle of some radius is provided. Such a system is represented by Fig. 3, wherein the path length along core 1 is greater than the path length of core 2. The two guides, which have exactly the same propagation constant at $\lambda_t$, when the fiber was straight, will be detuned. Two things happen as a result of the bending, the propagation constant in each core changes because of the stress induced by bending. Even if this were not so, the phases would not stay in step because of the change in path length. Of course, if the fiber is bent in the opposite direction to that shown in Fig. 3, detuning will occur in the opposite direction.

If dissimilar cores are assumed, instead of either tuning or detuning of all wave lengths, the wave length at which tuning occurs is changed.

Light can be either butt-coupled into core 1 or two separate cores are coupled to core 1 and core 2 so that the two paths are thereafter separated. The light filtered into core 2 is coupled laterally into another physically separate fiber.

A series of individual fibers laterally coupled is thereby provided as represented by Fig. 4.

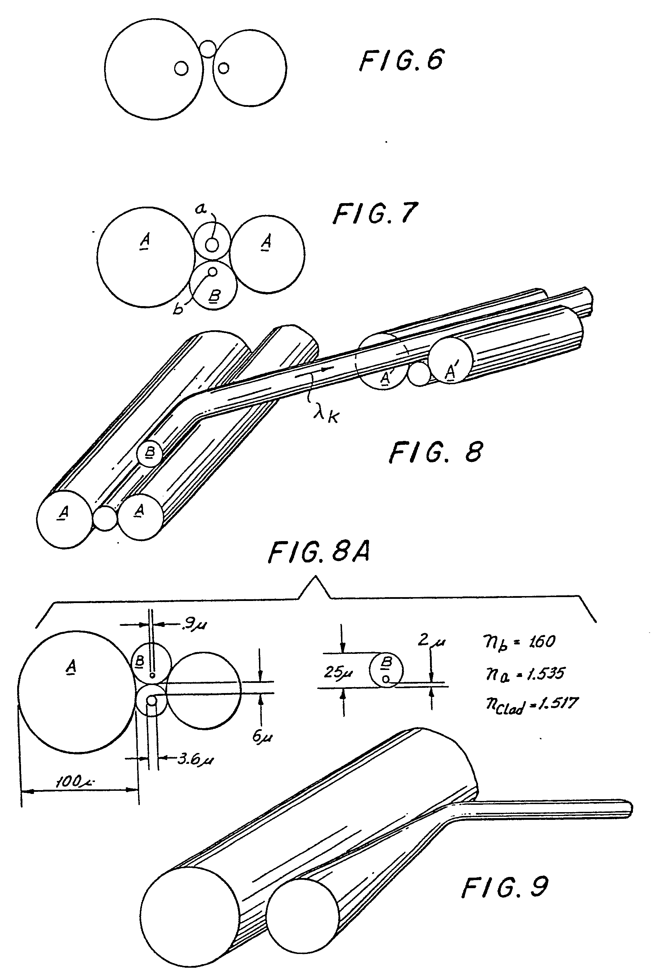

Still further, a single propagation device (Fig. 5) is bent into a number of circles of different radii, with a tap associated with each circle to accomplish a similar coupling network.

Also, a fiber can be gradually tapered to sweep through a series of tuned wave lengths. This is useful in a communications line to deliver signals to a number of homes along the road. As the fiber goes down the road, different wave lengths are tuned in. If a number of houses are spaced exactly 61 m apart and a series of wave lengths differing by 1 nm are to be delivered, this may be accomplished by tuning 1000 nm (=1 μm) at a first position, 1001 nm at a second position 61 m away, etc. Tuned lateral coupling over an appropriate length is provided to transfer the tuned wave length. Then non-tuned coupling is provided to tap off into each customer's service line. A combination of bending and tapering is used to provide even greater flexibility in such a network.

A communications network with selective coupling and tuning is applicable to non-circular cores also.

More specifically, in a fiber optics communications system, it is desirable to be able to send more than one signal over a fiber. Therefore, a means of introducing modulated light at several wavelengths onto one fiber and further means of separating these wavelength at the far end is advantageous.

Particularly in the terminal distribution networks, as opposed to the trunk lines, it is desirable to use wavelength multiplexing as a means of addressing individual subscribers. Clearly, it would be very expensive to carry a separate fiber from a sub-station to each subscriber. Any means for multiplexing several signals on one fiber and routing the signals to various subscribers must give reasonable security against a signal going to a wrong subscriber. It is therefore, unattractive to carry multiple signals off the main line into a subscriber's building for further addressing. On the other hand, addressing or tapping means at the telephone pole must operate in a rather hostile environment. For these reasons, addressing signals by shared time allocation is unattractive in a terminal distribution network.

It is a purpose of this invention to provide economical and efficient means of wave length multiplexing and demultiplexing. Alternate means from those used for the present invention are well known. The electromagnetic spectrum may be separated by prisms, diffraction gratings, etalons, and the like. All of these are ill suited to wavelength separation in a fiber optics system because of their size.

Let us take what is perhaps the best suited of the lot, namely a multi-layer filter. Such filters can be designed to reflect one narrow wavelength band and transmit other adjacent wavelengths. Such a filter could be introduced into a fiber optics system with three lenses about the size and complexity (and cost) of a microscope objective, and the lateral positioning of each element in the system would need to be held to a small fraction of the core diameter of the fibers. This clearly shows the impracticability of such an approach.

The distinguishing feature between a simple lateral coupler and a wave length filter; depending on frequency selective lateral coupling as used in the structures of the present invention is a difference in propagation dispersion between the cores to be coupled. The net effect is that at some wavelength $\lambda_k$ the two cores have equal propagation constants and as $\lambda$ departs from $\lambda_k$, the propagation constants become unequal. Thus, a high degree of coupling can be achieved at $\lambda_k$ and substantially less coupling at other wave lengths on each side of $\lambda_k$.

Dispersion, that is a variation of propagation constant with wave length, can be caused by the change in index of refraction of the core material with wave length or the change with wave length of the index of the cladding, or both. Dispersion is also a result of the wave guide geometry. Generally, if one considers single mode wave guides, the dispersion will be greater if the index difference between core and cladding is greater. As a very rough approximation—the wave guide dispersion is as follows:

$$\frac{\Delta_K}{K} = \frac{-1}{3} \Delta n \frac{\Delta \lambda}{\lambda}$$

Where K is the propagation constant (that is to say the constant in the z dependence of the wave equation):

$$\vec{E} = \vec{f}\ (x,y)\ e^{iKz}$$

and where:

$$\Delta n = n_{core} - n_{cladding}.$$

More complex geometries may be used. For instance, a pair of fibers which are relatively tightly coupled can be less tightly coupled to another pair of fibers:

A 0         o C

B 0         o D

It is well known that two coupled single mode fibers of identical propagation constants will exhibit two modes, a so called symmetric mode and an anti-symmetric mode. This splitting of the propagation constant is due to the interaction between the two. Likewise, C and D will have a symmetric and an anti-symmetric mode. Suppose A, B and C and D have identical indices, but C and D are of a slightly different diameter. The symmetric mode of A and B can be made equal to the anti-symmetric mode of C and D. However the dispersion of the symmetric and anti-symmetric modes will not be equal. Thus, for all other wavelengths the propagation constant will not be matched and the two fibers A and B will transfer energy to C and D at a selected wave length. This has been used to illustrate a sort of "synthetic" dispersion not the result of index dispersion nor of different indices of refraction in different cores.

Regarding the importance of single or monomode fibers in the context of the present invention, the following should be noted.

One can use two cores of identical index, but different diameters. In such arrangement, it would, however, not be possible to couple two single mode fibers. But one could couple the $HE_{11}$ mode of the smaller fiber to a higher order mode of the other. This arrangement has severe limitations in practice because several higher order modes are clustered together for a circular core and thus a wave length filter of this type would have several pass bands relatively close together rather than one isolated pass band. This could be somewhat alleviated by coupling a circular single mode fiber to a larger, non-circular (rectangular or elliptical) core. Even in this case, however, there would be at least two modes close together on the non-circular fiber, but the modes would be differently polarized. While a useful single band filter could be made this way by using a polarizer to reject one of the modes, the practicality of this approach would be marginal.

It should be pointed out that the very first direct observation of the wave guide nature of fiber optics made by Hicks in 1957 was of this type. He observed that very distinct saturated colors appeared in unilluminated fibers in fiber optics face plates due to cross talk. He correctly identified this as coupling between non-corresponding higher order modes of two cores of slightly different geometry. He also attributed the bright color to a difference in dispersion of the two modes.

All fiber optics face plates exhibit this effect and it is a well known phenomenon. However, the effect is not particularly useful as a wave length filter because of the very complex structure of the transfer bands.

Therefore the filters which are used for the purposes of the present invention have one mode in the wave length region to be used, so that only one transfer band occurs. (More properly, other transfer bands are spaced well away from the useful band and outside that portion of the spectrum to be used).

It is obvious that if a lateral coupling filter using two single mode cores is designed for use at one μm wave length, then at one-half μm wave length, there may be many modes and many transfer bands. Generally, these filters will be useful (limited to one band) only over 20% to 30% decrease in wave length.

Filters for this invention have been made using Schott Ba F-4 glass of index $n_d$=1.606 for one core and Schott ZK-5 glass of index $n_d$=1.534 for the second core. These cores have been imbedded in commercial soda lime glass (corning 0800) of index $n_d$=1.510. With this combination of indices, the following diameters were used:

$$Ba\ F\text{-}4\ core\ d_1 = .8\lambda$$

$$ZK\text{-}5\ core\quad d_2 = 3.6\lambda$$

where $\lambda$ is the wave length to be transferred. The diameters given are only approximate. Exact diameters can be calculated from the well known boundary value equations for circular dielectric wave guides. However, for cores this small a certain amount of diffusion of chemicals occurs between core and cladding so the idealized geometry is not realized. A certain amount of trial and error is required.

Filters were made using two cores in one cladding matrix. This is not too useful for a fiber optics communication system since one would like to take the filtered light signal off onto a branched line. One could accomplish this by a second lateral coupling to a second mechanically separate or separable fiber. This second coupling could be between two identical cores so that non-filtered coupling would take place.

It is difficult to hold two such fibers in close proximity over a coupling length. Therefore, composite fibers have been made from pre-forms, where a fragile bridging member holds the two fibers in fixed relation. This bridging member can be broken so that the fibers can follow different paths.

The bridging member can be differentially etchable to facilitate separating A and B. An advantage of this geometry is that the air gap between A and B effectively decouples them along the bulk of their length. At the branch point, a material of index nearly matching the cladding matrix can be introduced over one coupling length.

A simple geometry involving one transfer is shown in Fig. 6. The cores are of different diameters and indices so that a basic filter couple results.

Another geometry is shown in Fig. 7. A and B of Fig. 7 are not drawn together, but must be assembled to make a coupler. The geometry of fibers A provides a positioning jig for B. It is only necessary to orient the eccentric core b properly.

The fibers A are suitable for a transmission line. The fiber B has its core b so near the surface that it may have high transmission losses. In accordance with the present invention provision is made for transferring a second time to a branch line similar to A. (See Fig. 8). At 1 μm wavelength, for example, one might use the approximate dimensions shown in Fig. 8A. The coupling length for these dimensions would be about 8 cm. and the pass band would be about 0.5 nm. In the coupling region it is desirable to have A and B in good contact and to fill the voids with material matching the cladding in index.

The coupling length is very sensitive to spacing and air gaps and the 8 cm recommended is very approximate.

Many geometries have been examined and they have various advantages and disadvantages. The ones shown are intended to illustrate the point.

Consider now the problem of tuning the filter to pass a desired wavelength. If A or preferably B is slightly tapered along its length, tuning may be accomplished by the devices Fig. 9. Moving the coupling material either to a smaller or larger diameter as shown provides the desired result.

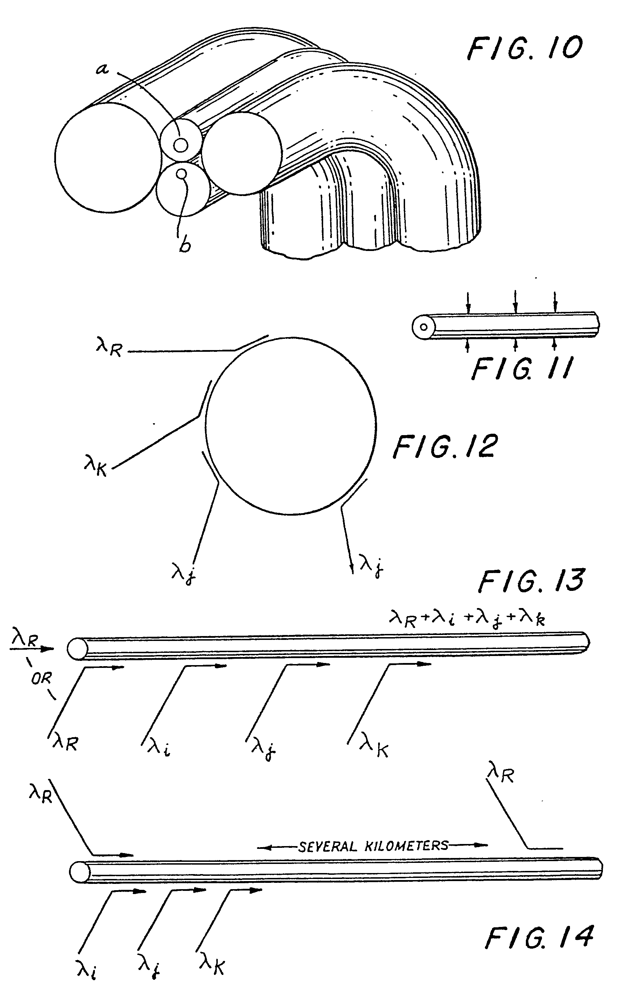

A second method of tuning is to bend the assembled array, as shown in Fig. 10. If a and b are tuned at λ=1 μm and are separated by 10 μm center to center, and are bent over a radius of 1 cm. for instance, the propagation constant must be shifted by

$$\frac{10 \ \mu m}{10,000 \ \mu m} = \frac{1}{1,000}$$

relative to each other to "resonate". With the indices used and using the approximate dispersion equation as follows:

$$\frac{\Delta_k}{k} = 1/3 \ \Delta n \ \frac{\Delta \lambda}{\lambda} = 1/3 \ (.0965) \ \frac{\Delta \lambda}{\lambda}$$

the tuned wavelength would shift about 30 nm. The direction of the shift would depend on the direction of the bend.

A third method of tuning depends on the variation of index of refraction with temperature. If the two cores have different temperature coefficients of index of refraction, a temperature change will change the tuning. For this reason, of course, it is desirable to use matching temperature coefficients where the filter is in an uncontrolled temperature environment.

Still another means of tuning results from the variation of index of refraction with stress. Either of the cores may be stressed separately, or if the stress coefficients are different for the two cores, then they may be stressed equally. For instance, one or both fibers could be stretched. Polarization effects can result in transfer band splitting if the stresses are applied transversely. In any case, one mode can be rejected with a polarizer.

When any of the above tuning devices is used to vary rather than to hold constant the tuned frequency, a switch is provided. That is to say if a signal at $\lambda_k$ is transmitted along a line, it can be switched onto a branch line by tuning the coupler to $\lambda_k$ or allowed to continue on the main line by detuning from $\lambda_k$.

Therefore, a tunable filter for switching, may be provided.

If the switching can be accomplished rapidly, the device can be used as a modulator or signal generator. Of the tuning means mentioned, the fastest is the application of transverse pressure, as shown in Fig. 11. If a pressure pulse is generated by some piezo-electric device and mechanically coupled into the side of the fiber by contact, it can generate a very short duration tuning pulse. Since the speed of a compression wave in glass is 3000 to 5000 meters per second, and since the high index core may be as small as 1 μm or even smaller then the tuning pulse will be of duration about $2 \times 10^{-10}$ seconds.

Although the pressure dependence of the index of refraction is not great, the filter may be made quite sensitive by increasing the coupling length.

Even temperature modulation will be relatively fast because of the very small transverse dimension of the core and the consequent very rapid cooling rate. Switching times of 1 micro second are possible.

Obviously if a filter coupler is constructed to be used as a switch, it will be sensitive to the variation of some parameter such as tension, curvature, temperature, pressure, or the like. It follows that such a device is useful as a transducer or measuring probe for the parameter to which it is sensitive. For example, if the two cores have substantially different temperature dependence of index of refraction, then a measurement of the exact resonant wavelength will reveal the temperature of the filter coupler. Since wavelength measurements can be made very accurately, such a temperature transducer is very sensitive and quick acting.

Although the pressure sensitivity is not great, a filter coupler is an accurate transducer for higher pressures. The sensitivity can be increased by using a construction as shown in Fig. 18.

The pair A, B has an anti-symmetric mode whose propagation constant crosses the symmetric mode of C, D for some λ. As the coupling increases, the cross over λ changes.

The concept of wavelength multiplexing in a fiber optics communication system is not new, but previously the means did not exist for efficient introduction of many wavelengths onto one fiber and the efficient separation of those wavelengths at the terminal end. Consequently, such systems were limited to 5 or 10 wavelengths at most. With the present invention, one might carry up to 200 signals over one fiber. It is, therefore, not only practicable to carry greatly increased bandwidths per fiber in a trunk line, but it is even possible to use wave length multiplexing as the principle means of addressing signals in a terminal distribution or acquisition system.

While the discussion has been implicitly in terms of a telephone-like system, it is not the intension to exclude "compact" systems such as an array of interconnected computers at one location. An optical switching station is an example of a compact system (Fig. 19). In the electronics art, n ports may be switched to m ports by a crossed array of lines with a switching diode at each intersection. There will be n×m diodes. For a large station 10,000 by 10,000 ports to be switchable would require $10^8$ diodes. The cost would be astronomical, particularly when video frequencies are to be switched.

By placing 10,000 "transmitters" at one end of a fiber and 10,000 receivers at the other end, such a switching station is provided. Let each transmitter have the capacity to select one of one hundred possible wavelengths and modulate that wavelengths at 100 times video rate for 5,000 pulses, for example, in one of one hundred possible time slots. Let the desired receiver know by other means what time and wavelength slot have been chosen. The receiver will tune its tunable filter coupler to the assigned λ during the assigned time slot and detune its filter to a small adjacent idle wavelength slot between time blocks.

In this sytem, each sender is, so to speak, "broadcasting" on one of 10,000 channels. All receivers have access to the broadcast energy. The assigned receiver "tunes" to that channel. In this system, there is a great savings of energy since none of the broadcast energy is uselessly extracted by other receivers. There is a high efficiency of delivery from sender to receiver.

Means for generating the signal are known to the optical communications art but the system will be illustrated with a specific means. If there is a Raman beam which generates 100 frequencies by selective optical feedback, let all frequencies be on a common fiber. Let each of the 100 senders have a tunable tap on this "frequency" bus. Sender tunes to λ; during the assigned time slot to extract a constant beam. This beam will then be modulated with some electrooptical modulator such as a Pockels cell. This signal is then injected as described onto the switching bus. Although this sytem is relatively expensive to begin with, the cost does not go up as the product of number of senders times number of receivers. It has, instead a fixed cost, for the Raman generator etc., plus a cost linearly proportioned to the number of senders plus number of receivers.

It is desirable in such a switching system to accumulate a signal at video rate and store it in a buffer memoery device and read out this signal at 100 times video rates. At the other receiving end, it is desirable to store this 100 times video rate signal in a memory and extract it at video rate.

The filter couplers which are used in this invention, can also be used to advantage in constructing such a buffer memory as well as in constructing other information processing and storing devices.

They may also be used to great advantage in optical delay lines, since one delay line can be multiplexed in wave length to store much more information. Also, the tunable switch is of great advantage in injecting information onto a closed delay line. If a delay line comprising a closed loop, as shown in Fig. 12 is provided, a series of pulses can be stored for as long as they will circulate before they become too attenuated to detect.

Of course, if the line is closed, it is impossible to inject or extract pulses, except by lateral coupling. The coupling must be tuned for the duration of the injection and detuned before the first pulse has made one trip around so that it won't then extract that pulse. Of course, the $\lambda_j$, $\lambda_k$, etc. switches operate independently since $\lambda_j$ will not extract much of $\lambda_k$ per trip around.

The storage time can be greatly increased by injecting a strong constant $\lambda_r$ of shorter wave length so the device becomes a Raman amplifier. If the signals are at 1 μm for instance, then the Raman generator beam should be at about 0.96 μm. The amplification need only be great enough to compensate for attenuation in the loop.

Amplification by stimulated Raman scattering is known in the art. The filter couplers provide the means for efficiently introducing the Raman generator beam onto the same fiber with several information signals.

In the same manner, a Raman generating beam may be introduced onto a fiber optics communication link, as shown in Fig. 13.

This allows one to use relatively weak signals and to amplify them after they are on the transmission line. There is, of course, an upper limit to which they can be amplified before they will become the parents of unwanted Raman offspring which will waste their substance.

However, the signals can be re-amplified at intervals after they have become attenuated by injecting another Raman beam onto the line (Fig. 14).

This is much more economical then demultiplexing, detecting and re-generating the signals for another length of run. The number of times this can be done will depend on several things, among them the inherent noisiness of this kind of amplification. Therefore, it is necessary to re-amplify before the signals are too weak.

The filter couplers may also be used to advantage in selectively filtering off and removing the wavelengths generated by the signals when they in turn generate longer wave length beams by stimulated Raman scattering.

## Claims

1. Optical communication transmission system comprising a main transmission wave guide for supporting optical wave energy at a plurality of wave lengths, at least one branch wave guide coupled to the main wave guide for transferring, between said main and branch wave guides, wave energy at but a single predetermined one of said plurality of wave lengths, said transfer of wave energy between said main and each branch wave guide being achieved utilizing the principle of frequency-selective lateral evanescent wave coupling under which the wave guides so coupled are arranged in proximate parallel relationship over a coupling length and are selected to have dispersion characteristic curves different from one another over said coupling length but crossing at the desired coupling wave length, whereby the two coupled wave guides will have matching phase propagation constants at said coupling wave length only, whereas there will be mismatch of phase propagation constants between the two coupled wave guides over the coupling length for all other wave lengths, characterized in that

— (a) coupling between the main wave guide and each branch wave guide is via a coupling wave guide,
— (b) said main, branch and coupling wave guides are non-planar optical fibres each comprising a core circumferentially embedded in a cladding;
— (c) said fibre wave guides are of the kind selected to support waves in a single mode only;
— (d) the main guide and each coupling wave guide are selected to have different dispersion characteristics of phase velocity of the optical wave energy over the coupling length and each coupling wave guide, over its coupling length with the main wave guide, is of a physical condition imparting to the coupling wave guide a phase velocity of the optical wave energy at said one wave length which matches the phase velocity of said one wave length in the main guide, whereby energy at said coupling wave length to the exclusion of all other wave lengths is transferred from the main guide to the respective coupling wave guide;
— (e) and each coupling wave guide is laterally coupled to a branch wave guide for further transmitting optical energy at said coupling wave length.

2. The system according to claim 1, characterized in that the coupling region between each coupling wave guide and its associated branch wave guide is geometrically separate and spatially distant along the length of the coupling wave guide from the coupling region between the main wave guide and the coupling wave guide.

3. The system according to claim 1 or claim 2; characterized in that the main wave guide and/or the branch wave guide at least over their respective coupling lengths with the coupling wave guide are in the form of composite parallel double fibre structures (A—A; A'—A') forming a jig for supporting said coupling wave guide (B) in its lateral coupling relationship with said main and/or branch wave guide.

4. The system according to claim 3, characterized in that said composite parallel double fibre structures (A—A; A'—A', Fig. 7 and 8) comprise bridging members holding the two fibre components of each composite structure in a predetermined parallel distance.

5. The system according to any of the preceding claims, characterized in that said coupling wave guide (B, Fig. 7) is a fibre wherein the core is eccentrically arranged relative to the cladding.

6. The system according to any of the preceding claims, characterized in that said dispersion characteristics is caused primarily as a result of material index dispersion, of wave guide dispersion, of a combination thereof.

7. The system according to any of the preceding claims, characterized in that the relationship between said dispersion characteristics is caused primarily as a result of said main wave guide having a relatively smaller diameter and a relatively greater index of refraction with respect to said coupling wave guide.

8. The system according to any of the preceding claims, wherein at least one of said main wave guide and said coupling wave guide is tapered to enable wave lengths selection at a point along said main wave guide.

9. The system according to any of the preceding claims, characterized in that one of said main wave guide and said coupling wave guide is adjustable relative to the other.

10. The system according to any of the preceding claims characterized in that said frequency-selective coupling between said main and branch wave guides is variably tunable to a certain wave length by bending of said main wave guide and coupling wave guide in a plane including both of said structures, or by means of temperature variation thereof, or by means of stress variation thereof, or by means of electric field exposure thereof, or by means of magnetic field exposure thereof, or combinations thereof.

**Patentansprüche**

1. Optisches Kommunikations-Übertragungssystem umfassend einen Haupt-Übertragungs-Wellenleiter für die Unterhaltung optischer Wellenenergie bei mehreren Wellenlängen, wenigstens einen mit dem Hauptwellenleiter gekoppelten Zweig-Wellenleiter zur Übertragung von Wellenenergie bei nur einer vorgegebenen der genannten mehreren Wellenlängen zwischen dem Haupt- und dem Zweigwellenleiter, wobei die Übertragung von Wellenenergie zwischen dem Haupt- und jeweils jedem Zweigwellenleiter unter Anwendung des Prinzips der frequenzselektiven seitlichen Evaneszenzwellenkopplung erfolgt, gemäß welchem die so gekoppelten Wellenleiter über eine Kopplungslänge eng benachbart und parallel zueinander angeordnet und so gewählt sind, daß ihre Dispersionkennlinien über die genannte Kopplungslänge voneinander verschieden sind, sich jedoch an der gewünschten Kopplungswellenlänge überkreuzen, derart daß die beiden gekoppelten Wellenleiter nur bei der genannten Kopplungswellenlänge übereinstimmende Phasenausbreitungskonstanten besitzen, während für alle anderen Wellenlängen über die Kopplungslänge eine Fehlanpassung der Phasenausbereitungskonstanten zwischen den beiden Kopplungswellenlängen vorliegt, dadurch gekennzeichnet, daß

— (a) die Kopplung zwischen dem Hauptwellenleiter und jeweils jedem Zweigwellenleiter über einen Kopplungswellenleiter erfolgt,

— (b) der genannte Haupt- und die Zweig- und Kopplungswellenleiter nicht-planare optische Faserleiter sind, die jeweils einen entlang ihrem Umfang in eine Umhüllung eingebetteten Kern bzw. Core umfassen,

— (c) die genannten Faserwellenleiter von der Art gewählt sind, daß sie Wellen nur in einem einzigen Mode unterhalten,

— (d) der Hauptwellenleiter und jeweils jeder Kopplungswellenleiter so gewählt sind, daß sie über die Kopolungslänge unterschiedliche Dispersionskennlinien der Phasengeschwindigkeit der optischen Wellenenergie aufweisen und jeweils jeder Kopplungswellenleiter über seine Kopplungslänge mit dem Hauptwellenleiter einen solchen physikalischen Zustand besitzt, der dem Kopplungswellenleiter eine Phasengeschwindigkeit der optischen Wellenenergie bei der genannten einen Wellenlänge verleiht, welche mit der Phasengeschwindigkeit der genannten einen Wellenlänge in dem Hauptleiter übereinstimmt, derart, daß Energie bei der genannten Kopplungswellenlänge unter Ausschluß aller anderen Wellenlängen von dem Hauptwellenleiter auf den entsprechenden Kopplungswellenleiter übertragen wird;

— (e) und daß jeweils jeder Kopplungswellenleiter lateral an einen Zweigwellenleiter gekoppelt ist, zur weiteren Übertragung optischer Energie bei der genannten Kopplungswellenlänge.

2. System nach Anspruch 1, dadurch gekennzeichnet, daß der Kopplungsbereich zwischen jeweils jedem Kopplungswellenleiter und seinem zugeordneten Zweigwellenleiter geometrisch getrennt und in räumlichen Abstand entlang der Länge des Kopplungswellenleiters von dem Kopplungsbereich zwischen dem Hauptwellenleiter und dem Kopplungswellenleiter vorliegt.

3. System nach Anspruch 1 oder Anspruch 2, dadurch gekennzeichnet, daß der Hauptwellenleiter und/oder der Zweigwellenleiter wenigstens über ihre jeweiligen Kopplungslängen mit dem Kopplungswellenleiter in Form paralleler Doppelfaser-Verbundgebilde (A—A; A'—A') vorliegen, welche eine Paßlehre zur Halterung des Kopplungswellenleiters (B) in dessen Lateral-Kopplungsbeziehung bezüglich dem genannten Haupt- und/oder Zweigwellenleiter bildet.

4. System nach Anspruch 3, dadurch gekennzeichnet, daß die genannten Parallel-Doppelfaser-Verbundgebilde (A—A; A'—A', Fig. 7 und 8) Überbrückungsglieder umfassen, welche die beiden Faserkomponenten jedes jeweiligen Verbundgebildes in einem vorgegebenen parallelel Abstand halten.

5. System nach einem der vorhergehenden Ansprüche, dadurch gekennzeichnet, daß der genannte Kopplungswellenleiter (B, Fig. 7) eine Faser mit bezüglich ihrer Umhüllung exzentrisch angeordnetem Kern bzw. Core ist.

6. System nach einem der vorhergehenden Ansprüche, dadurch gekennzeichnet, daß die genannten Dispersionseigenschaften primär als Ergebnis von Material-Brechungs-Index-Dispersion, von Wellenleiter-Dispersion oder einer Kombination hiervon, hervorgerufen sind.

7. System nach einem der vorhergehenden Ansprüche, dadurch gekennzeichnet, daß die Beziehung zwischen den genannten Dispersionseigenschaften primär als Ergebnis davon hervorgerufen ist, daß der Hauptwellenleiter einen relativ kleineren Durchmesser und einen relativ größeren Brechungsindex bezogen auf den Kopplungswellenleiter besitzt.

8. System nach einem der vorhergehenden Ansprüche, bei welchem von dem genannten Hauptwellenleiter und dem genannten Kopplungswellenleiter wenigstens einer sich verjüngend ausgebildet ist, um eine Wellenlängen-selektion in einem Punkt entlang dem Hauptwellenleiter zu ermöglichen.

9. System nach einem der vorhergehenden Ansprüche, dadurch gekennzeichnet, daß von dem genannten Hauptwellenleiter und dem genannten Kopplungswellenleiter einer relativ bezüglich dem anderen einstellbar veränderbar ist.

10. System nach einem der vorhergehenden Ansprüche, dadurch gekennzeichnet, daß die genannte frequenzselektive Kopplung zwischen dem Haupt- und den Zweigwellenleitern auf eine vorgegebene Wellenlänge veriabel abstimmbar ist, und zwar durch Biegen des genannten Hauptwellenleiters und Kopplungswellenleiters in einer beide Gebilde enthaltenden Ebene, oder mittels Temperaturveränderung, oder mittels mechanischer Spannungsänderung oder mittels einer elektrischen Feldbeaufschlagung oder mittels einer Magnetfeldbeaufschlagung der Gebilde oder Kombinationen hiervon.

**Revendications**

1. Système de transmission optique de communications comportant un guide d'ondes principal de transmission pour supporter une énergie d'ondes optiques à plusieurs longueurs d'onde, au moins un guide d'ondes en dérivation couplé au guide d'ondes principal pour transférer, entre lesdits guides d'ondes principal et en dérivation, une énergie d'ondes à juste une seule longueur d'onde prédéterminée desdites plusieurs longueurs d'onde, ledit transfert d'énergie d'onde entre le guide d'ondes principal et chaque guide d'ondes en dérivation étant réalisé en utilisant le principe du couplage d'ondes latéral évanescent sélectif en fréquence, en vertu duquel les guides d'ondes ainsi couplés sont agencés de manière rapprochée et parallèle sur une longueur de couplage et sont choisis pour avoir des courbes de caractéristiques de dispersion différentes les unes des autres sur ladite longueur de couplage mais se croisant à la longueur d'onde de couplage souhaitée, grâce à quoi les deux guides d'ondes couplés n'ont des constantes de propagation de phase concordantes qu'à ladite longeur d'onde de couplage, alors qu'il y a discordance des constantes de propagation de phase entre les deux guides d'ondes couplés sur la longueur de couplage pour toures les autres longueurs d'onde, caractérisé en ce que

— (a) le couplage entre le guide d'ondes principal et chaque guide d'ondes en dérivation se fait par l'intermédiaire d'un guide d'ondes de couplage;

— (b) lesdits guides d'ondes principal, en dérivation et de couplage sont des fibres optiques non planes comprenant chacune une âme enrobée sur tout son pourtour par un recouvrement;

— (c) lesdits guides d'ondes en fibres sont du type choisi pour supporter des ondes dans un seul mode;

— (d) le guide principal et chaque guide d'ondes de couplage sont choisis pour avoir des caractéristiques différentes de dispersion de la vitesse de phase de l'énergie d'ondes optiques sur la longueur de couplage et chaque guide d'ondes de couplage, sur sa longueur de couplage avec le guide d'ondes principal, a un état physique qui donne au guide d'ondes de couplage une vitesse de phase de l'énergie d'ondes optiques à une longueur d'onde qui concorde avec la vitesse de phase d'une longueur d'onde du guide principal, grâce à quoi l'énergie à ladite longueur d'onde de couplage, à l'exclusion de toutes les autres longueurs d'onde, est transférée du guide principal au guide d'ondes de couplage correspondant;

— (e) et chaque guide d'ondes de couplage est couplé latéralement à un guide d'ondes en dérivation pour encore transmettre de l'énergie optique à ladite longueur d'onde de couplage.

2. Système selon la revendication 1, caractérisé en ce que la région de couplage entre chaque guide d'ondes de couplage et son guide d'ondes en dérivation correspondant est géométriquement séparée et spatialement distante, le long du guide d'ondes de couplage, de la région de couplage entre le guide d'ondes principal et le guide d'ondes de couplage.

3. Système selon la revendication 1 ou la revendication 2, caractérisé en ce que le guide d'ondes principal et/ou le guide d'ondes en dérivation, au moins sur leurs longueurs respectives de couplage avec le guide d'ondes de couplage sont sous forme de structures composites (A—A; A'—A') à deux fibres parallèles formant un montage pour supporter le guide d'ondes de couplage (B) dans ses relations de couplage latéral avec lesdits guides d'ondes principal et/ou en dérivation.

4. Système selon la revendication 3, caractérisé en ce que les structures composites (A—A; A'—A', Fig. 7 et 8) à deux fibres parallèles comportent des éléments de pontage maintenant les deuxfibres constituant chaque structure composite séparées par une distance prédéterminée et parallèles.

5. Système selon l'une quelconque des revendications précédentes, caractérisé en ce que la guide d'ondes de couplage (B, Fig. 7) est une fibre dans laquelle l'âme est disposée de manère excentrée par rapport au recouvrement.

6. Système selon l'une quelconque des revendications précédentes, caractérisé en ce que lesdites caractéristiques de dispersion sont provoquées principalement par suite de la dispersion des indices des matières, de la dispersion des guides d'ondes ou d'une combinaison de celles-ci.

7. Système selon l'une quelconque des revendications précédentes, caractérisé en ce que les relations entre lesdites caractéristiques de dispersion sont provoquées principalement par suite du fait que le guide d'ondes principal a un diamètre relativement plus petit et un indice de réfraction relativement plus éléve comparativement à ceux du guide d'ondes de couplage.

8. Système selon l'une quelconque des revendications précédentes, dans lequel au moins un desdits guide d'ondes principal et guide d'ondes de couplage est conique pour permettre le choix des longueurs d'onde en un point du guide d'ondes principal.

9. Système selon l'une quelconque des revendications précédentes, caractérisé en ce qu'un desdits guide d'ondes principal et guide d'ondes de couplage est réglable par rapport à l'autre.

10. Système selon l'une quelconque des revendications précédentes, caractérisé en ce que le couplage sélectif en fréquence entre les guides d'ondes principal et en dérivation est accordable de manière variable à une certaine longueur d'onde en coudant le guide d'ondes principal et le guide d'ondes de couplage dans un plan englobant les deux structures, ou au moyen d'une variation de température de ceux-ci, ou au moyen d'une variation de la contrainte de ceux-ci, ou au moyen d'une exposition de ceux-ci à un champ électrique, ou au moyen d'une exposition de ceux-ci à un champ magnétique ou par des combinaisons de ces moyens.

0 037 793

FIG.1

FIG.2

FIG.3

CORE 1
CORE 2

FIG.4

$f_1$  $f_2$  $f_3$

FIG.5

1

*FIG.6*

*FIG.7*

*FIG. 8*

$\lambda_K$

*FIG.8A*

$.9\mu$

$2\mu$

$25\mu$

$n_b = 1.60$

$n_a = 1.535$

$n_{Clad} = 1.517$

$6\mu$

$3.6\mu$

$100\mu$

*FIG.9*

FIG. 10

FIG. 11

FIG. 12

FIG. 13

FIG. 14

*FIG. 15*

*FIG. 16*

*FIG. 17*

*FIG. 18*

CLADDING GLASS

HOLLOW CAVITY

*FIG. 19*

DIODE